Europäisches Patentamt

European Patent Office

Office européen des brevets

(11) Veröffentlichungsnummer: **0 085 393**
**B1**

(12) **EUROPÄISCHE PATENTSCHRIFT**

(45) Veröffentlichungstag der Patentschrift:
30.04.86

(51) Int. Cl.⁴: **H 03 H 7/48, H 01 P 5/12**

(21) Anmeldenummer: **83100718.2**

(22) Anmeldetag: **26.01.83**

(54) **Mikrowellen-Verstärkereinrichtung.**

(30) Priorität: **28.01.82 DE 3202711**

(43) Veröffentlichungstag der Anmeldung:
**10.08.83 Patentblatt 83/32**

(45) Bekanntmachung des Hinweises auf die Patenterteilung:
**30.04.86 Patentblatt 86/18**

(84) Benannte Vertragsstaaten:
**BE FR GB IT NL**

(56) Entgegenhaltungen:
**DE - A - 3 009 232**
**DE - B - 2 308 884**
**GB - A - 1 319 096**
**US - A - 3 662 285**
**US - A - 4 124 823**
**US - A - 4 291 278**

**Patent Abstract of Japan vol. 5, no. 19, 4. Februar 1981**
**NACHRICHTEN ELEKTRONIK, Januar 1980 K.**
**SCHÜNEMANN "Prinzipien der Leistungs-Addition aus**
**Halbleiter-Elementen", Seiten 5-9**

(73) Patentinhaber: **Siemens Aktiengesellschaft, Berlin und München Wittelsbacherplatz 2, D-8000 München 2 (DE)**

(72) Erfinder: **Honold, Peter, Dipl.-Ing., Guardinistrasse 49, D-8000 München 70 (DE)**

**Beschreibung**

Die Erfindung bezieht sich auf eine Mikrowellen-Verstärkereinrichtung, bei der an eine Eingangsleitung über ein Wellenleiter-Verteilernetzwerk mit ihren Eingängen mehrere Verstärker-Moduln widerstandsangepaßt angeschlossen sind, die mit ihren Ausgängen über ein entsprechend ausgebildetes Wellenleiter-Summiernetzwerk ebenfalls widerstandsangepaßt mit einer Ausgangsleitung verbunden sind, so daß sich eine Parallelschaltung der Verstärker-Moduln ergibt, von denen jeder bei Anschluß an die beiden Netzwerke an seinem Eingang und seinem Ausgang mit dem Eingangs- bzw. Ausgangswellenleiter über ein durch eine Öffnung in das Innere des Eingangs- bzw. Ausgangswellenleiters ragendes Koppelelement verbunden ist, das so ausgebildet ist, daß widerstandsangepaßt eine bestimmte Teilenergie aus- bzw. eingekoppelt wird.

Bei der Entwicklung von Mikrowellen-Leistungsverstärkern z.B. für Radarsender besteht das Problem, daß ein einzelner Transistor eine im Vergleich zu den früher verwendeten Röhren nur sehr geringe Ausgangsleistung zu liefern vermag. Das Problem wird in üblicher Weise dadurch gelöst, daß eine entsprechend große Anzahl von Transistor-Verstärkerstufen parallel geschaltet wird. Für die Aufteilung der Stufeneingangsleistung und die Aufsummierung der Ausgangsleistung bedient man sich entsprechender passiver Netzwerke.

Bei einer geringen Anzahl, z.B. acht, parallel zu schaltender Stufen verwendet man hierfür meist in Serie geschaltete Binärteiler, z.B. Wilkinson-Teiler, in einer Tannenbaumstruktur. Hierbei nehmen jedoch die Verluste des Netzwerkes mit größer werdender Anzahl von Ausgängen rasch zu.

Bei einer noch größeren Anzahl parallel zu schaltender Verstärkerstufen verwendet man gewöhnlich sternförmige Anordnungen, bei denen im Falle des eingangsseitigen Verteilers die Verstärkereingangsseiten über widerstandstransformierende Leitungen an einen zentralen Speisepunkt angeschlossen sind. Die des zu verstärkende Signal führende Eingangsleitung ist mit diesem zentralen Speisepunkt verbunden. Das Summiernetzwerk, das die Ausgangssignale der einzelnen Verstärker zusammenfaßt und an eine Ausgangsleitung führt, verhält sich reziprok zum beschriebenen eingangsseitigen Verteilernetzwerk.

Eine Variante dieser bekannten Lösung besteht darin, daß die Übertragung vom zentralen Speisepunkt, an den die Signaleingangsleitung geführt ist, zu den Verstärkereingängen in Form einer elektromagnetischen Welle innerhalb eines Wellenleiters verläuft. Genauso und mit reziproker Wirkung sind zwischen den Ausgängen der Verstärker und einem zentralen Verbindungspunkt Wellenleiter vorgesehen. Die notwendige Widerstandsanpassung der Ein- und Ausgänge wird hierbei durch Art und Dimensionierung der Koppelelemente zwischen der leitungsgebundenen Welle und der Raumwelle realisiert. Eine derartige Anordnung, bei der als Koppelelemente über Koaxialanschlüsse eingeführte Koppelschleifen verwendet werden, ist aus "Patent Abstracts of Japan", Vol.5, No.19, 4.Februar 1981, JP-A-55 147 003 bekannt.

Bei modularem Aufbau, der aus vielerlei Gründen bevorzugt wird, ist es bekannt, daß jeder Einzelverstärkermodul einer solchen Verstärkereinrichtung über je eine Koaxial-Steckverbindung mit dem Wellenleiter-Verteilerbzw. mit dem Wellenleiter-Summiernetzwerk verbunden wird. Bei einer großen Anzahl von Parallelverstärkern bedeuten diese Steckverbindungen jedoch insbesondere wegen der hohen Anzahl sowie der gerade bei einer hohen Anzahl besonders schwierigen Justage einen sehr hohen Aufwand und einen nennenswerten Kostenanteil an der gesamten Verstärkereinrichtung.

Aus der US-A-41 24 823 ist ein Mikrowellenkoppler bekannt, bei dem eine Eingangsleitung in einen rechtwinkligen, in einem Teilbereich mittels zweier Platten in drei Kammern unterteilten Hohlleiter eingeführt ist. Aus jeder dieser drei Kammern wird eine Teilenergie ausgekoppelt und jeweils der Eingangsseite eines Verstärkers zugeführt. Die Ausgangsenergie der Verstärker wird in drei Kammern eines zweiten rechtwinkligen Hohlleiters eingekoppelt und dann an einer Ausgangsleitung entnommen. Die Hohlleiter sind in gleicher Weise aufgebaut, arbeiten aber reziprok. Eine Auskoppeleinrichtung für eine solche Kammer soll im folgenden etwas eingehender erläutert werden. Auf einer horizontal verlaufenden Trennplatte ist eine Microstrip-Leitung in der Mitte zwischen zwei senkrecht verlaufenden Seitenwänden fest angebracht. Der auf der Oberseite der Microstrip-Leitung befindliche Streifenleiter ist mechanisch und elektrisch mit einer Kante einer sich verjüngenden Transformatorplatte verbunden, deren andere Kante mit der oberen Hohlleiterinnenfläche verbunden ist, so daß die Transformatorplatte in der Mitte von und parallel zu den beiden Hohlleiterseitenwänden angeordnet ist. Dieser Sachverhalt geht aus Spalte 3, Zeilan 24 bis 30 der US-A-4 124 823 hervor. Die leitende Unterseite der Microstrip-Leitung liegt auf der Transformatorplatte und auf der Unterkante einer Öffnung im Hohlleiter auf. Das Koppelelement der kammer besteht somit aus der leitenden Oberseite der Microstrip-Leitung und der sich verjüngenden, senkrecht verlaufanden Platte. Wesentlich ist dabei, daß die das Koppelelement bildenden Teile im rechtwinkligen Hohlleiter angebracht sein müssen. Der Verstärker muß mit seinen Eingangsanschlüssen eigens an die Microstrip-Leitung, welche über die Öffnung hinaus aus dem Hohlleiter herausragt, angeschlossen werden. Zur Verbindung müssen beispielsweise eigene Steckvorrichtungen, Klemmen oder Lötverbindungen vorgesehen sein. Diese eigens vorzusehenden Verbindungseinrichtungen bedeuten bei einer großen Anzahl von Parallelverstärkern jedoch insbesondere wegen der hohen Anzahl sowie der gerade bei einer hohen Anzahl besonders schwierigen Justage ähnlich wie bei koaxialen Steckverbindungen einen sehr hohen Aufwand und einen nennenswerten Kostenanteil an der gesamten Verstärkereinrichtung. Bei der Anordnung nach US-A-4 124 823 können die Verstärker an die beiden Wellenleiter-Netzwerke nicht ohne weiteres, d.h. ohne Leitungen, aufgesteckt werden, da die Verstärker-Moduln räumlich zwischen den beiden rechtwinklig ausgebildeten Hohlleiter-Netzwerken anzubringen sind.

Aufgabe der Erfindung ist es, eine aus mehreren parallel geschalteten Einzelverstärkermoduln bestehende Mikrowellen-Verstärkereinrichtung zu schaffen, die demgegenüber ohne besondere Steck- oder Lötverbindungen zwischen den Moduleingängen bzw. -ausgängen einerseits und den zugeordneten Eingangs- bzw. Ausgangswellenleitern andererseits auskommt und somit wesentlich weniger aufwendig ist, wobei noch dazu sehr gute Koppeleigenschaften erreicht werden.

Gemäß der Erfindung, die sich auf eine Mikrowellen-Verstärkereinrichtung der eingangs genannten Art bezieht, wird diese Aufgabe dadurch gelöst, daß am Eingang und am Ausgang jedes Verstärker-Moduls als Koppelelement jeweils eine nach außen abstehende Koppelschleife fest angebracht und derart angeordnet ist, daß sie beim Anschluß des Moduls an die beiden sternförmig mit den Moduln bestückbaren und mit zentral angeordneter Ein- bzw. Ausgangsleitung versehenen Netzwerke durch die zugeordnete Öffnung des Eingangs- bzw. Ausgangswellenleiters hindurchreicht und in dessen Inneres hineinragt, und daß die Koppelschleifen derart symmetrisch ausgebildet sind, daß an den Verbindungsstellen jeweils zwischen den Verstärkermoduln und dem Wellenleiternetzwark keine Gehäusewandströme fließen. Beim Aufsetzen der Verstärker-Moduln auf die beiden Wellenleiter-Netzwerke ergibt sich zwangsläufig ein wunschgemäßes Eintauchan der Koppelschleifen in die jeweiligen Wellenleiter.

Sollte die Verstärkerschaltung in den einzelnen Verstärker-Moduln auf einer Substratplatte aufgebaut sein, so läßt sich gemäß einer vorteilhaften Weiterbildung der Erfindung diese Platte so erweitern und ausformen, daß sie zugleich die Koppelschleifen trägt, die dann im angeschlossenen Zustand der Verstärkermoduln ins Innere der jeweiligen Wellenleiter ragen.

Durch die Erfindung ergibt sich darüber hinaus der Vorteil, daß die bei der Montage zahlreicher paralleler Verstärkermoduln bisher aufgetretenen mechanischen Toleranzprobleme weitgehend vermieden werden.

Die Erfindung wird im folgenden anhand von drei Figuren erläutert. Es zeigen

Fig. 1 das bekannte Schaltungsschema eines sternförmigen Verteilernetzwerks auf der Verstärkereingangsseite,

Fig. 2 die Schrägansicht einer bekannten Wellenleiterausführungsform eines solchen Netzwerkes und

Fig. 3 eine teilweise aufgeschnittene Teilansicht einer Mikrowellen-Verstärkereinrichtung nach der Erfindung.

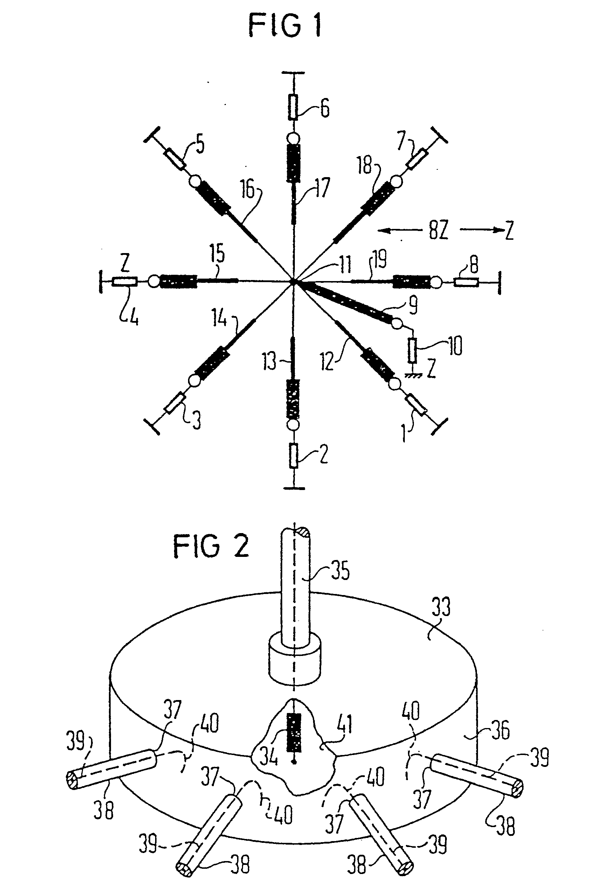

Mittels des in Fig. 1 schematisch dargestellten sternförmigen Verteilernetzwerks sollen auf ihrer Eingangsseite beispielsweise acht Mikrowellen-Verstärker 1 bis 8 zusammengeschaltet werden. Diese Verstärker 1 bis 8 sind nicht als Verstärker, sondern mit ihren jeweils übereinstimmenden Eingangswiderständen Z dargestellt. Gespeist werden die Verstärker 1 bis 8 von einer zentralen Eingangsleitung 9, die einen Wellenwiderstand Z aufweist und an ihrer dem Verteilernetzwerk abgewandten Seite von einer Schaltung 10 gespeist wird, die ebenfalls nicht als solche, sondern nur mit ihrem Ausgangswiderstand Z gezeigt ist. Diese Eingangsleitung 9 ist an einen zentralen Speisepunkt 11 im sternförmigen Netzwerk angeschlossen. Die Verstärker 1 bis 8 sind über widerstandtransformierende Leitungen 12 bis 19 an den zentralen Punkt 11 angeschaltet. Es findet im dargestellten Beispiel in jeder der Verbindungsleitungen 12 bis 19 vom Punkt 11 bis zur Anschlußstelle des jeweiligen Verstärkers 1 bis 8 eine Transformation vom Wellenwiderstand 8Z auf den Wellenwiderstand Z statt.

Das Summiernetzwerk auf der Ausgangsseite der parallel geschalteten Verstärker 1 bis 9 ist genauso aufgebaut wie das in Fig. 1 dargestellte eingangsseitige Verteilernetzwerk. Es arbeitet lediglich reziprok dazu, d.h. die Leitung 9 ist dann eine zentrale Ausgangsleitung, die Schaltung 10 mit dem Widerstand Z eine die verstärkten und zusammengefaßten Signale aufnehmende Schaltung und der zentrale Punkt 11 im Netzwerk diejenige Stelle des Summiernetzwerks, an welcher die Leistungen der einzelnen Verstärker summiert, d.h. zusammengefaßt werden.

Fig. 2 zeigt in einer Schrägansicht ein Verteilernetzwerk für die Verstärkereingangsseite, das aus einem tortenschachtelförmigen, in der Zeichnung aus Verdeutlichungsgründen in einem Bereich 41 aufgeschnittenen Wellenleiter 33 besteht und funktionell dem Netzwerk nach Fig. 1 entspricht. Eingespeist wird das auf acht Verstärker zu verteilende Eingangssignal an einer zentralen Speisestelle 34 über eine koaxiale Eingangsleitung 35. An der umlaufenden Wand 36 weist der Wellenleiter 33 Auskoppelöffnungen 37 z.B. zum Anschliessen von koaxialen Leitungen 38 auf, deren Innenleiter 39 als Koppelelemente 40 enden. Die koaxialen Leitungen 38 sind mit ihren dem Wellenleiter 33 abgewandten Enden jeweils mit der Eingangsseite eines Verstärkers verbunden. Das Summiernetzwerk auf der Ausgangsseite der Verstärker ist nicht eigens zeichnerisch dargestellt, ist aber genauso ausgebildet wie der eben beschriebene Verteiler-Wellenleiter 33 und arbeitet reziprok dazu.

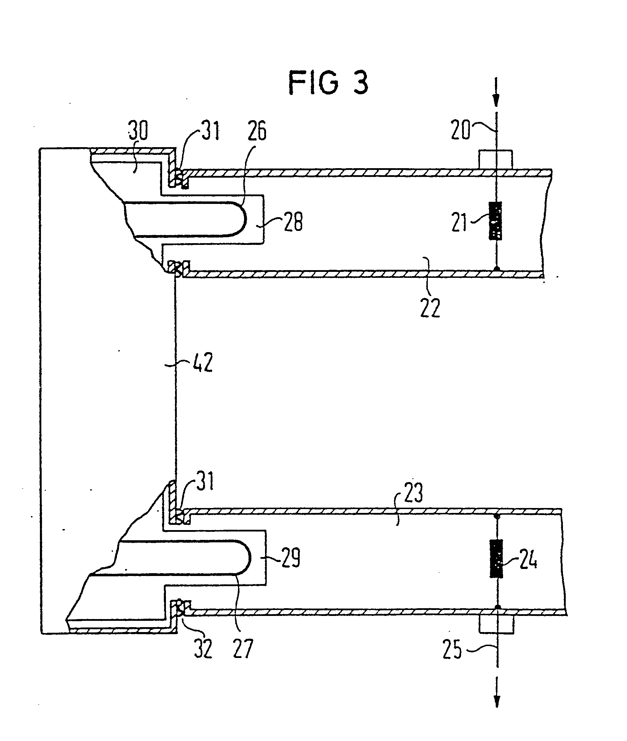

Fig. 3 zeigt einen Ausschnitt einer Mikrowellen-Verstärkereinrichtung nach der Erfindung in teilweise aufgeschnittener Ansicht. Es ist lediglich ein einziger Verstärkermodul 42 dargestellt, da sich die gezeichnete Anordnung bei allen anderen, dazu parallel zu schaltenden Verstärkermoduln wiederholt. Das zu verstärkende und von einer Eingangsleitung 20 kommende Eingangssignal wird an einem Eingang 21, der dem zentralen Speisepunkt 11 in Fig. 1 bzw. 34 in Fig. 2 entspricht, in den Verteiler-Wellenleiter 22 eingekoppelt, von dem nur ein Sektor in Fig. 3 dargestellt ist. Dieser Sektor des Verteiler-Hohlleiters 22 entspricht einer der Leitungen 12 bis 19 in Fig. 1. Übereinstimmend mit der eben erläuterten Eingangsseite der Verstärkereinrichtung ist die reziprok arbeitende Ausgangsseite ausgebildet, nämlich mit einem Summier-Wellenleiter 23, von dem nur ein Sektor dargestelltist, mit einem zentralen Ausgangspunkt 24 und einer Ausgangsleitung 25, in die das leistungsmäßig verstärkte und zusammengefaßte Ausgangssignal eingekoppelt wird. Die Übertragung vom zentralen Speisepunkt 21 zu den einzelnen Verstärkereingängen bzw. von den einzelnen Verstärkerausgängen zum zentralen Ausgangspunkt 24 verläuft somit in Form einer elektromagnetischen Welle. Jeder der parallel zu schaltenden Verstärkermoduln, von denen in Fig. 3 lediglich der Modul 42 dargestellt ist, trägt an seinem Eingang und an seinem Ausgang eine Koppelschleife 26 bzw. 27. Mit der Auskoppelschleife 26 wird Signalenergie aus dem Verteiler-Wellenleiter 22 in den Verstärkermodul 42 zur nachfolgenden Verstärkung ausgekoppelt. Umgekehrt wird mit der Einkoppelschleife 27 verstärkte Signalenergie aus dem Verstärkermodul 42 in den Summierwellenleiter 23 eingekoppelt. Die Koppelschleifen 26 und 27 sind auf Lappen 28 bzw. 29 einer Substratplatte 30, welche die Schaltungselemente des Verstärkermoduls 42 trägt, angeordnet und ragen in das Innere der Wellenleiter 22 bzw. 23. Die Koppelschleifen 26 und 27 sind so gearbeitet und dimensioniert, daß Widerstandsanpassung vorliegt. Die Koppelschleifen 26 und 27 sind derart symmetrisch ausgebildet, daß an den Verbindungsstellen zwischen dem Verstärkermodul 42 und den Wellenleitern 22 bzw. 23 keine Gehäusewandströme fließen.

Die Schirmung zwischen den Gehäuseöffnungen der stumpf aufeinanderstoßenden Moduln 42 und dem Verteilernetzwerk 22 bzw. dem Summiernetzwerk 23 erfolgt durch gewellte Federbleche 31 bzw. 32. Dadurch sind in allen Freiheitsgraden relativ große mechanische Toleranzen zulässig.

**Patentansprüche:**

1. Mikrowellen-Verstärkereinrichtung, bei der an eine Eingangsleitung (20) über ein Wellenleiter-Verteilernetzwerk mit ihren Eingängen mehrere Verstärker-Moduln (30) widerstandsangepaßt angeschlossen sind, die mit ihren Ausgängen über ein entsprechend ausgebildetes wellenleiter-Summiernetzwerk ebenfalls widerstandsangepaßt mit einer Ausgangsleitung (25) verbunden sind, so daß sich eine parallelschaltung der Verstärker-Moduln ergibt, von denen jeder bei Anschluß an die beiden Netzwerke an seinem Eingang und seinem Ausgang mit dem Eingangs- bzw. Ausgangswellenleiter (22 bzw. 23) über ein durch eine Öffnung in das Innere des Eingangs- bzw. Ausgangswellenleiters ragendes Koppelelement (26,27) verbunden ist, das so ausgebildet ist, daß widerstandsangepaßt eine bestimmte Teilenergie aus- bzw. eingekoppelt wird, dadurch gekennzeichnet, daß am Eingang und am Ausgang jedes Verstärker-Moduls (42) als Koppelelement jeweils eine nach außen abstehende Koppelschleife (26,27) fest angebracht und derart angeordnet ist, daß sie beim Anschluß des Moduls an die beiden sternförmig mit den Moduln bestückbaren und mit zentral angeordneter Ein- bzw. Ausgangsleitung (20,25) versehenen Netzwerke durch die zugeordnete Öffnung des Eingangs- bzw. Ausgangswellenleiters (22,23) hindurchreicht und in dessen Inneres hineinragt, und daß die Koppelschleifen (26,27) derart symmetrisch ausgebildet sind, daß an den Verbindungsstellen jeweils zwischen den Verstärkermoduln (42) und dem Wellenleiternetzwerk keine Gehäusewandströme fließen.

2. Mikrowellen-verstärkereinrichtung nach Anspruch 1, dadurch gekennzeichnet, daß eine gegebenenfalls vorgesehene Substratplatte (30) des Verstärkermoduls (42) so erweitert und ausgeformt ist, daß sie zugleich die Koppelschleifen (26,27) trägt.

3. Mikrowellen-Verstärkereinrichtung nach Anspruch 1 oder 2, gekennzeichnet durch die Verwendung als Leistungsverstärker, beispielsweise in einem Radarsender.

**Claims:**

1. A microwave amplifier device, wherein a plurality of amplifier modules (30) have their inputs connected to an input line (20) by means of a waveguide distributing network so as to be impedance matched, which amplifier modules have their outputs connected via a correspondingly constructed waveguide summing network to an output line (25) so as to be equally impedance matched, so that a parallel circuit of the amplifier modules is established, each of which has its input and its output connected to the input and output waveguide (22 and 23) by means of a coupling element (26, 27), which protrudes through an opening into the inside of the input and output waveguide, when connected to the two networks, which coupling element is contrived to be such that a specific partial energy is input or output coupled so as to be impedance matched, <u>characterised in that</u> at the input and at the output of each amplifier module (42) an outwardly protruding coupling loop (26, 27) is firmly fixed as a coupling element and arranged in such a manner that on connection of the module to the two networks, which can be equipped with the modules in a star-like fashion and are provided with centrally arranged input and output lines (20, 25), it protrudes through the assigned opening of the input and output waveguide (22,23) and into the inside thereof, and that the coupling loops (26, 27) are symmetrically constructed in such a manner that housing wall currents do not flow at the junctions between the amplifier modules (42) and the waveguide network.

2. A microwave amplifier device as claimed in Claim 1, <u>characterised in that</u> a possibly provided substrate plate (30) of the amplifier module (42) is expanded and moulded in such a manner that it simultaneously supports the coupling loops (26, 27).

3. A microwave amplifier device as claimed in Claim 1 or 2, <u>characterised by</u> use as a power amplifier, for example in a radar transmitter.

## Revendications

1. Dispositif amplificateur à micro-ondes, dans lequel à une ligne d'entrée (20) se trouvent raccordées, par l'intermédiaire d'un réseau de distribution à guides d'ondes, avec adaptation des impédances, les entrées de plusieurs modules amplificateurs (30) qui sont également reliés par leurs sorties, à une ligne de sortie (25) par l'intermédiaire d'un réseau de sommation de guides d'ondes, conçu de façon correspondante, de telle sorte que l'on obtient un circuit parallèle des modules amplificateurs, dont chacun est relié, lors du raccordement aux deux réseaux, au niveau de son entrée et de sa sortie au guide d'ondes d'entrée ou de sortie (22 ou 23) par l'intermédiaire d'un organe de couplage (26,27) pénétrant à l'intérieur du guide d'ondes d'entrée ou de sortie et qui est conçu de telle sorte qu'une énergie partielle déterminée est extraite par découplage ou injectée par couplage, avec adaptation des impédances, caractérisé par le fait que respectivement une boucle de couplage (26,27) faisant saillie à l'extérieur est montée fixe à l'entrée et à la sortie de chaque module amplificateur (42) sous la forme d'un organe de couplage et est disposée de telle sorte que lors du raccordement du module aux deux réseaux qui peuvent être équipés avec les modules selon un montage en étoile et qui sont munis d'une ligne d'entrée ou d'une ligne de sortie (20,25) disposée en position centrale, cette boucle traverse l'ouverture associée du guide d'onde d'entrée ou de sortie (22, 23) et pénètre à l'intérieur de ce guide d'ondes, et que les boucles de couplage (26,27) sont agencées en étant symétriques de telle sorte qu'aucun courant de paroi de boîtier ne circule, au niveau des points de liaison, respectivement entre les modules amplificateurs (42) et le réseau de guides d'ondes.

2. Dispositif amplificateur à micro-ondes suivant la revendication 1, caractérisé par le fait qu'une plaque de substrat (30), éventuellement prévue, du module amplificateur (42) est élargie et conformée de telle sorte qu'elle porte simultanément les boucles de couplage (26,27).

3. Dispositif amplificateur à micro-ondes suivant la revendication 1 ou 2, caractérisé par son utilisation en tant qu'amplificateur de puissance, par exemple dans un émetteur radar.

# FIG 1

# FIG 2

## FIG 3